# EUROPEAN PATENT APPLICATION

(11) **EP 4 084 070 A1**
(43) Date of publication of application: **02.11.2022**
(21) Application number: 20907132.3
(22) Date of filing: 09.03.2020
(51) Int. Cl.: H01L 27/02

(54) **NOVEL PRINCIPLES AND TECHNOLOGY FOR SEMICONDUCTOR ELECTRONICS, AND DEVICE**

(30) Priority: 28.12.2019 CN 201911426662
(71) Applicant: Wang, Keming, Guiyang, Guizhou 550001 (CN); Wang, Runze, Guiyang, Guizhou 550001 (CN)
(72) Inventor: Wang, Keming, Guiyang, Guizhou 550001 (CN); Wang, Runze, Guiyang, Guizhou 550001 (CN)
(74) Representative: Sach, Greg Robert
(86) International application number: PCT/CN2020/000042
(87) International publication number: WO 2021/128435

(57) **Abstract**

A new semiconductor electronic principle technology and device is a fundamental change in semiconductor science and technology. the new semiconductor electronic principle guessed and Validation from reality, fully reflects the essence of semiconductor electronic devices, and correctly understand and guide the work of semiconductor electronic devices, It is revealed that the function of semiconductor electronic devices is to convert electrical signals, which are converted by the voltage applied to junctions, P-N junctions, semiconductor metal junctions or insulator metal junctions that can be formed in a variety of semiconductor materials, changing the carrier density distribution on both sides of the junctions and junctions, modulated the conductivity and resistivity of the junctions, exponential variation of the conductivity of the passive semiconductor electronic devices formed by the junction alone or in combination with the difference between the applied voltage and the transistor threshold voltage, and modulating the conductivity of the semiconductor electronic devices and completing the conversion of electrical signals; New semiconductor electronic principles, technologies, passive semiconductor electronic devices, code, software and operating systems based on conductivity change, replacing current semiconductor electronic principles, technologies, active semiconductor electronic devices, current code, software and operating systems for all semiconductor electronic technologies and devices based on current change; A new semiconductor electronic device with high stability, reliability and low power loss is invented to effectively solve the key problems such as heating of semiconductor electronic devices, to maintain normal, stable and reliable work in ambient temperature below 80°C, to reduce the cost of products, and to solve the urgent breakthrough in the fields of driverless, artificial intelligence and intelligent medicine. It relates to semiconductor electronic principle and technology, device structure and working principle, circuit design, develop new code, software and new operating system, device manufacture and material product function and characteristic, belongs to semiconductor electronic technology field.

## Description

### TECHNICAL AREAS

The invention is a fundamental change in semiconductor science and technology, the new semiconductor electronic principle guessed and Validation from reality, fully reflects the essence of semiconductor electronic devices, and correctly understand and guide the work of semiconductor electronic devices. A new semiconductor electronic principle, technology, passive semiconductor electronic device and a matching new software and new operating system based on conductivity change replace the current semiconductor electronic principle, technology, active semiconductor electronic device and current software and operating system in all semiconductor electronic technologies and devices based on current change. It involves semiconductor electronic principle and technology, device structure and working principle, circuit design, software development and creation of new operating system, device manufacturing and materials, product function and characteristics, and belongs to the field of semiconductor electronic technology.

### BACKGROUND TECHNOLOGY

1947 John Bardeen it was found that the semiconductor conductivity can be modulated by the input current at the appropriate contact point, so with William Shockley and Walter Houser Brattain invented transistors, the current semiconductor electron theory based on current change is established. Now semiconductor electron theory holds that transistors are active components, Using current as independent variable, transistors are divided into unipolar field effect transistor and bipolar junction transistor with different structure, conduction mechanism, working principle and calculation equation. The principle of bipolar junction transistor is to generate and control emitter current from the injected current from the base (most carriers are controlled by minority carriers). The working principle of unipolar field effect transistor is: gate voltage induction and control drain current (field effect theory: transverse current is controlled by vertical electric field). The birth of integrated circuits has made semiconductor science and technology develop rapidly, widely used in all science and technology, from mobile communications, electronic computers, weapon systems to space science and technology, semiconductor science and technology has become the most important subject today. But with the rapid development and wide application of semiconductor electronic science and technology, in the face of increasing demands for improving the functionality and quality of semiconductor electronics, now semiconductor electronic theory and technology has been unable to effectively solve the problems of stability, reliability, power loss, speed and volume, and become the bottleneck restricting the development of semiconductor science and technology, as a result, it is believed that the development of semiconductor science and technology has reached its limit (published articles by the Journal of Science in 2000).In the Internet age of all things, the data is growing geometrically, and the ability, speed, stability and reliability of processing data are rising. Therefore, devices and chips with stronger performance, higher stability and reliability and lower energy loss are needed. The only way to solve this major problem is the fundamental change of semiconductor science and technology.

The inventor has been engaged in electronic technology since 1957. In practice, he has found some problems that the current semiconductor electronic theory does not conform to the facts. Mainly: bipolar junction transistor and unipolar field effect (MOS) transistor why should two P-N junction reverse series composition? How does a transistor consisting of two P-N junctions in reverse series work differently? The current semiconductor electron theory: when the bipolar junction transistor works, the collector is an inverse bias voltage. Because the collector junction is a P-N junction, according to the principle of the P-N junction, the inverse bias P-N junction is a high impedance barrier layer, and the forward current cannot pass through. Therefore, the emitter current cannot reach the collector and become the collector current through the collector junction; similarly, the drain of a unipolar field effect (MOS) transistor operates with an inverse bias voltage, and the drain junction is also a P-N junction. According to the principle of P-N junction, the reverse bias P-N junction is a high impedance barrier layer, and the forward current cannot pass through, the source current cannot reach the drain through the drain junction and become the drain current. Therefore, the understanding of the current theory is untenable, but the collector current and the drain current are objective, so it is necessary to re-understand the working principle of the transistor. Current semiconductor theory holds that both bipolar junction transistors and unipolar field effect transistors are active current components, based on current changes as the basis for understanding and analysis. In bipolar junction transistors, the current injected from the base generates and controls the emitter current, or the voltage added to the base generates and controls the emitter current. The transistor's working state is determined by the base current, the collector current is linear, and the base current is linearly related to the collector current: I_{c}=βI_{B}+(β+1)I_{cBo}, reverse saturation current I_{cBo} change of (β+1) times is the root cause of increasing transistor power loss, generating instability and reducing reliability, and it is considered that the reverse saturation current is determined by the material and process of manufacturing transistors, which is an inevitable problem for transistors. The emitter current is determined only by the current injected from the base, independent of the change of collector voltage and load impedance. But the fact is: the emitter current is much larger than the base current, how does the current injected from the base generate the emitter current? And make emitter current mutation? What is the mechanism that causes emitter current generation and mutation? If were I_{c}=βI_{B}+(β+1)I_{cBo} since the base current and the collector current are two independent current circuits, how does the base current amplify the collector current? What is the mechanism for amplifying collector current? For each transistor β is the current magnification factor variable or constant and determined by which parameters? According to the present theory, since the current injected from the base electrode produces the emitter current in the bipolar junction transistor, the current injected from the base electrode at any value should produce the emitter current, but the fact is that the working state of the transistor is independent of the current injected into the base, when the voltage added to the base is below a certain value, the transistor is in a cutoff state, what determines the transistor in the on or off state is the voltage added to the base, not the current injected into the base, and the collector current of the bipolar junction transistor is related to the change of the collector voltage and the load impedance. The current semiconductor electron theory holds that the voltage induced drain current (FET) is added to the gate, and the voltage added to the gate is linearly related to the drain current, and the transconductance represents the amplification ability of the transistor, Gₘ=ΔI_{D} (µA)/Δu_{gs}(v), the drain current is linear, the drain current is determined only by the voltage applied to the gate, independent of changes in drain voltage and load impedance. But the truth is, the drain current of a unipolar field effect transistor is nonlinear, among unipolar field effect transistors (MOS field effect transistors), since it's a voltage on the grid, so if you add any voltage to the gate, but the truth is, when the voltage added to the gate is below a certain value, the transistor is in a cutoff state, the drain current of unipolar field effect transistor is related to the change of drain voltage and load impedance. For answers: The inventor has studied semiconductor theory and technology at his own expense since 1975, after more than 45 years of intensive research, extensive experiments and specific solutions to a range of practical problems, the current semiconductor electron theory based on current change, including the field effect theory, its basic principle cannot be established. After 16 years of constant research and reflection, finally find a way to verify the above understanding. The verification circuit is a kind of "common bipolar junction transistor transformer coupled type B push-pull amplifier", which can accurately determine the operating state of the transistor (transistor conductivity change)". By gradually increasing the input signal voltage, measure each step of the work data and images, analysis of all working data and images, from nine relationships, respectively, it can be verified and irrefutable that the transistor works as a change in conductivity, the current flowing through the transistor, Just a dependent variable with the conductivity of the transistor, so as to deny the current semiconductor theory based on current change, including the field effect theory, to create a new semiconductor electron theory based on conductivity change.

〈〈The New Semiconductor Electron Theory 〉〉 Published in the United States by the United States Tate Publishing on 8 October 2013, Book number: ISBN : 978-1-62510-438-0, Author: Wang Keming Wang Runze. An article in the book, 〈〈A New Principles of Semiconductor Electron Devices〉〉 , 〈〈A New Understanding of Semiconductor Conductivity Modulation〉〉 , 〈〈P-N Junction〉〉 , Member David E. Aspnes Professor, American Academy of Sciences, Professor Walter L. Brown and a number of scientists from the American Academy of Sciences from January 2004 to February 2008 for more than four years of continuous review, Praise the verification circuit, and US journal Applied Physics Letters, of recommendations Published in the US Journal of Applied Physics and IEEE, And it was passed four times PNAS( Proceedings of the American Academy of Sciences), And in the PNAS manuscript library, prove that these articles are correct and valuable.

### SUMMARY OF THE INVENTION

The purpose of the invention is to provide a new principle, technology, device and software and operating system for correct, reliable and efficient conversion of electrical signals, to correctly understand and apply semiconductor electronic devices and technologies, to effectively solve the problems of stability, reliability, power loss, fever heat, speed and volume, to improve the ability and speed of processing data with devices with stronger performance, higher stability reliability and lower energy loss, to solve the urgent breakthrough in new fields such as driverless, artificial intelligence, and intelligent medical treatment, and to promote the continuous development of semiconductor science and technology.

The invention discloses that the function of a semiconductor electronic device is to convert electrical signals. The conversion of electrical signals is accomplished by modulating the conductivity of semiconductor electronic devices. Conductivity modulation is fundamental to semiconductor electronic technology and devices. The new semiconductor electronic principle, technology and passive semiconductor electronic devices based on conductivity change are used in all semiconductor electronic equipments, give full play to the functions and characteristics of semiconductor electronic devices, effectively solve the key problems such as fever heat of semiconductor electronic theory and technology, and ensure the realization of the purpose.

Current is the continuous movement of electrons under external force, and is a dependent variable with the applied voltage, the electrical conductivity of electronic devices and the loop impedance vary. Current is a phenomenon, not the essential characteristic of matter. The injection current can only increase the number of moving electrons by the same amount, cannot produce current and make current mutation, because there is no mechanism to make current generation and mutation. Therefore, the current semiconductor electronic principle based on current change cannot correctly reflect the conductive mechanism and working principle of semiconductor electronic devices, and cannot effectively solve a series of key problems such as fever heating in semiconductor theory and technology.

Conductivity is the basic characteristic of matter, indicating the conductivity of matter, which is determined by the free carrier density of matter. The conductivity of semiconductor is between conductors and insulators, and the wide conductivity modulation region is the best material for the manufacture of electronic devices. The conductivity of pure semiconductor and free carrier density uniform semiconductor cannot be modulated because there is no mechanism to modulate conductivity. By doping on a semiconductor substrate, two regions with different carrier density, or electromagnetic fields, are formed, changing the carrier density distribution in the semiconductor, forming two regions with different carrier density, or semiconductor contact with metal, forming two regions with different carrier density, or insulator contact with metal, forming two regions with different carrier density, when two different regions of carrier density are connected, the carrier density is different, the majority carrier diffuses to the minority carrier region, the carrier density distributes according to the exponential law and forms the junction built-in voltage, the carrier density and junction built-in voltage are interdependent exponential relationships, at the junction of the positive and negative charge region, the positive charge carrier density is equal to the negative charge carrier density, and the free carrier density is zero, forming a junction with very low conductivity, high resistivity and electric neutrality. When a voltage is added to the positive and negative charge region, the carrier density distribution on both sides of the junction and junction varies exponentially with the difference between the applied voltage and the junction built-in voltage. When there is a small change in the applied voltage on the junction, the carrier density on both sides of the junction and the junction to the exponential law, so by changing the voltage added to the positive and negative charge region, change the carrier density on both sides of the junction and junction, the conductivity and resistivity of the modulated junction. A junction formed in a semiconductor, with the function of modulating the conductivity of a semiconductor, is a mechanism for modulating the conductivity of a semiconductor, and P-N junction is a typical one.

When a P-N junction is formed on a semiconductor substrate, a positive bias voltage is added to the P-N junction higher than the built-in voltage, the carrier density of the P-N junction is higher than the equilibrium carrier density, the P-N junction conduction, the voltage is called threshold voltage, the carrier density of the P-N junction varies exponentially with the difference between the applied voltage and the threshold voltage, the conductivity and resistivity of the P-N junction vary with the carrier density, the conductivity and resistivity of the P-N junction change exponentially with the difference between the voltage added to the P-N junction and the threshold voltage, and the current flowing through the P-N junction changes with the P-N junction impedance. The P-N junction is composed of P-type, N-type and electrically neutral junctions, and is a variable impedance with directional adjustable conductivity. Since the applied voltage only changes the carrier density distribution and conductivity of the p-n junction, p-n does not generate current and is therefore a passive element.

P-N junction built-in voltage is the threshold voltage of the P-N junction, when the positive bias voltage added to the P-N junction is lower than the threshold voltage, the carrier density of the P-N junction is lower than the equilibrium carrier density and the P-N junction is the cutoff state. When the reverse bias voltage is added to the P-N junction, the P-N junction is a cutoff state. When the reverse bias voltage is twice higher than the threshold voltage, the P-N junction is reversed and the reverse current is flowing through in the P-N junction.

The transistor threshold voltage is formed by the diffusion of the majority carrier to the minority carrier region, which is the carrier density difference, which is determined by the intrinsic carrier density and the doping density of the semiconductor material. The intrinsic carrier density is a function of temperature, increases with the increase of temperature, and decreases with the decrease of temperature, so the P-N junction built-in voltage decreases with the increase of temperature and increases with the decrease of temperature. Because the P-N junction built-in voltage is the threshold voltage of the transistor, the transistor threshold voltage is a function of temperature. When the transistor temperature rises, the intrinsic carrier density increases, the threshold voltage decreases, the difference between the positive bias voltage and the transistor threshold voltage increases, the junction carrier density increases, the conductivity increases and the resistivity decreases, the junction impedance decreases and the current flowing through the junction increases, the change of transistor threshold voltage with temperature, resulting in the change of the operating state of the transistor with temperature, and the working characteristics of the transistor are changed, and the instability and reliability decreases, when the vicious cycle is formed, the elevated transistor temperature will burn out the transistor and electronic equipment. When the transistor temperature decreases, the intrinsic carrier density decreases, the threshold voltage rises, the difference between the positive bias voltage and the transistor threshold voltage decreases, the junction carrier density decreases, the conductivity decreases and the resistivity increases, as the junction impedance increases and the current flowing through the junction decreases, the transistor operating characteristics are changed, resulting in instability and reduced reliability. When the positive bias voltage is lower than the transistor threshold voltage, the carrier density of the junction is lower than the equilibrium carrier density, and the transistor is in the cutoff state, and the transistor will stop working when it is serious, the change of transistor threshold voltage with temperature which is determined by the intrinsic carrier density and doping density of semiconductor materials, is the root cause of transistor instability and reduced reliability.

The functions of semiconductor electronic devices are to convert electrical signals, applying the new principle of semiconductor electronics based on changes in conductivity, electromagnetic fields changing the carrier density distribution of semiconductors to form regions with different carrier density and conductivity, forming junctions in semiconductors with the function of modulating semiconductor conductivity, P-N junctions being a passive element with directional conductivity adjustable impedance variable, conductivity and resistivity of P-N junctions being exponential with the difference between the voltage applied to the P-N junction and the threshold voltage as a function of temperature, a junction, P-N junction or semiconductor metal junction that can be formed in a variety of semiconductor materials, individually or in combination into passive semiconductor electronic devices, and a passive transistor with high stability, high reliability, fast switching speed and low power loss for all semiconductor electronic devices; A junction formed in semiconductors, or in semiconductor contact with metal, or in insulator contact with metal, having the function of modulating electrical conductivity, for the composition of electronic devices for conversion of electrical signals and photoelectric, con operating on the principles and characteristics of junctions and for use in electronic devices.

### DETAILED DESCRIPTION

High stability, reliability and low power loss semiconductor electronic devices:
W diode: a low resistance thermistor Rₜ connected in series with a positive temperature coefficient on a P-N junction or a semiconductor metal junction, Fig .1, the working voltage is added to a W diode through a thermistor, the thermistor is at the same temperature as a W diode. According to the new semiconductor electronics principle, the P-N junction is a variable impedance with directional conductivity adjustable, the positive bias voltage is added to the W diode. When the positive bias voltage is higher than the W diode threshold voltage, the junction carrier density of the W diode is higher than the equilibrium carrier density, the conductivity and resistivity of the W diode vary exponentially with the difference between the voltage added to the W diode and the threshold voltage, the current flowing through the W diode changes with the junction impedance to complete the conversion of electrical signals; When the positive bias voltage added to the W diode is lower than the W diode threshold voltage, the junction carrier density of the W diode is lower than the equilibrium carrier density, and the W diode is in the cut-off state. When the reverse bias voltage is added to the W diode, the W diode is reversed and produces reverse current.

When the temperature of the W diode rises, the intrinsic carrier density increases, the threshold voltage decreases, and the temperature of the positive temperature coefficient thermistor connected in series with the W diode rises synchronously, the resistance value increases, the voltage drop increases, the positive bias voltage on the W diode decreases synchronously, the difference between the positive bias voltage and the W diode threshold voltage remains constant and the W diode works stably; When the temperature of the W diode decreases, the intrinsic carrier density decreases, the threshold voltage increases, and the temperature of the positive temperature coefficient thermistor at the same temperature of the W diode decreases, the resistance value decreases and the voltage drops, the difference between positive bias voltage and W diode threshold voltage is constant, the w diode operates stably and is a semiconductor electronic device with high reliability and low power loss.

W Triode Transistor: according to the conductivity is directly modulated by the voltage added to the modulation pole, and indirectly modulated by the voltage added to the modulation pole changing the carrier density distribution in the channel, differentiated into w directness modulation transistor and w indirectness modulation transistor.

W direct modulation transistor: W direct modulation transistor consists of two P-N junctions in reverse series, the two P-N junctions are the modulation junction at the source terminal and the drain junction at the drain terminal, and the modulation pole between the modulation junction and the drain junction, modulation pole is connected with a low resistance thermistor Rₜ with a positive temperature coefficient, Fig .2.

The working principle of W direct modulation transistor is that one of the two P-N junctions in reverse series is always reverse bias and the transistor is in the cutoff state. When the positive bias voltage added to the modulation junction is higher than the threshold voltage, the modulation junction of the transistor is on-state, so the reverse bias voltage added to the W direct modulation transistor drain makes the drain junction reverse, the w direct modulation transistor changes from two P-N junctions in reverse series to two P-N junctions in forward series, the drain junction of the W direct modulation transistor becomes positive bias after being reversed, the conductivity of the positive bias drain junction is very high and the resistivity is very low, the reverse drain junction becomes a thoroughfare that allows high current to pass through, the operation of the transistor is determined only by the difference between the voltage added to the modulation junction and the transistor threshold voltage, and changes with the modulation junction impedance. Since the P-N junction is a variable impedance with directional adjustable conductivity, and the modulation junction is a P-N junction, the carrier density of the modulation junction varies exponentially with the difference between the voltage added to the modulation junction and the transistor threshold voltage, the conductivity of the modulation junction varies exponentially, the resistivity and impedance of the modulation junction vary with the conductivity, and the current flowing through the transistor changes with the modulation junction impedance. In circuits composed of supply voltage, load impedance and transistor impedance, the current flowing through the transistor changes with the difference between the voltage added to the modulation junction and the threshold voltage of the transistor, which is related to the change of the supply voltage and the load impedance, and completes the amplification and conversion of the electrical signal. The above working principle shows that the W direct modulation transistor is operated by two parts, the voltage added to the modulation pole changes the conductivity of the modulation junction, and the resistivity and impedance vary with the conductivity. Therefore, in the circuit composed of the supply voltage, the load impedance and the W direct modulation transistor impedance, the current flowing through the W direct modulation transistor varies with the impedance of the transistor modulation junction, which is related to the change of the supply voltage and the load impedance. Therefore, the voltage added to the modulation pole only changes the conductivity, resistance and impedance of the modulation junction, as a result, the current flowing in the W direct modulation transistor changes with the modulation junction impedance to complete the conversion and amplification of electrical signals.

The positive bias voltage and signal voltage of the W direct modulation transistor modulation pole are added to the modulation junction through a low resistance thermistor with positive temperature coefficient. According to the new semiconductor electronic principle, the P-N junction is a variable impedance with directional adjustable conductivity, the thermistor with positive temperature coefficient is in series with a variable impedance, and the voltage drop of the thermistor varies with temperature and impedance; When the temperature of the W direct modulation transistor rises, the intrinsic carrier density of the modulation junction increases, the threshold voltage decreases, and the temperature of the thermistor rises synchronously, the impedance increases and the voltage drop increases, the positive bias voltage and signal voltage on the W direct modulation transistor modulation junction decrease synchronously, and the difference between the sun of positive bias voltage with the signal voltage added to the modulation junction and the transistor threshold voltage remains constant, the W direct modulation transistor works stably; When the temperature of the W direct modulation transistor decreases, the modulation junction intrinsic carrier density decreases, the threshold voltage increases, while the temperature of the positive temperature coefficient thermistor decreases synchronously, the impedance decreases and the voltage drops, the positive bias voltage and signal voltage on the W direct modulation transistor modulation junction increase synchronously, the difference between the sun of positive bias voltage with the signal voltage added to the modulation junction and the transistor threshold voltage remains constant without temperature change, the operation of the W direct modulation transistor and the tube temperature stability, and the transistor power loss decreases.

W indirect modulation (MOS) transistor: W-indirectness modulation (MOS) transistors are divided into P-W-indirectness modulation (MOS) transistors and N-W-indirectness modulation (MOS) transistors according to whether the semiconductor substrate is P- or N-type, the principle of P-W-indirectness modulation (MOS) transistors is exactly the same as that of N-W-indirectness modulation (MOS) transistors.

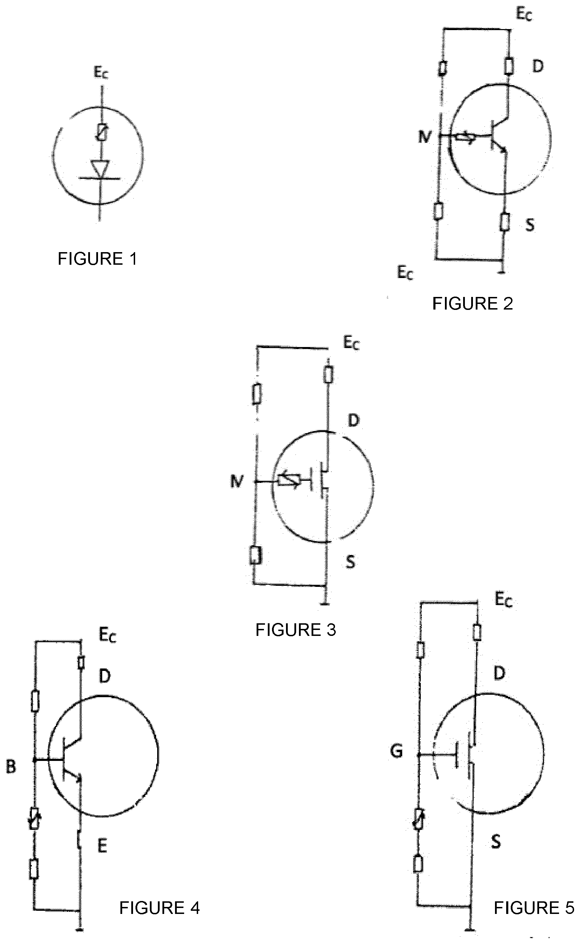

The P type W indirect modulation (MOS) transistor diffuses two highly doped N regions on the P semiconductor substrate, leads to the electrode, becomes the source electrode and the drain electrode, and the two N-regions and the P-regions form two P-N junctions in reverse series, and the two P-N junctions are the modulation junction and the drain junction at the source and drain ends, respectively, a very thin oxide layer is grown on the substrate surface, and then the metal layer is deposited on the oxide layer, connecting a low resistance thermistor Rₜ with positive temperature coefficient, leading the electrode to become the modulation pole, fig.3. The principle of the P-type W indirect modulation (MOS) transistors is that When there is no positive voltage at the modulation pole, a P-N junction of two reverse series on the source-channel-drain channel is always an inverse bias, W indirect modulation (MOS) transistors are in a cutoff state; when the reverse bias voltage is added to the drain and the positive bias voltage is added to the modulation pole, the positive bias voltage added to the modulation pole induces electron charge at the boundary of the oxide layer in the P channel, which changes the carrier density distribution in the P region and forms the N-type conductive region, a new P-N junction and the establishment of an electric field are formed by the diffusion of most carriers in the P-type and N-type conductive regions, the field voltage is forward on the modulation junction, the electron density, the field voltage and the conductivity of the N-type conductive region increase with the increase of the positive bias voltage, and the carrier density of the modulation junction increases with the decrease of the difference between the field voltage and the threshold voltage, When the carrier density of the modulation junction increases to equal to or above the equilibrium carrier density, the field voltage rises to equal to or above the threshold voltage, and the modulation junction of the transistor is on, so the reverse bias voltage added to the drain of the W-indirectness modulation (MOS) transistor causes the drain to reverse, the drain junction of the W-indirectness modulation (MOS) transistor becomes positive bias after being reversed, the conductivity of the positive bias drain junction is very high and the resistivity is very low, and the drain junction becomes a thoroughfare that allows a large current to pass through after the reverse-type, the operation of the transistor is determined only by the difference between the sum of positive bias voltage and signal voltage added to the modulation pole and the threshold voltage of the transistor, and changes with the modulated junction impedance. According to P-N junction is a variable impedance with directional adjustable conductivity, when the sum of positive bias voltage and signal voltage added to the modulation pole is lower than the threshold voltage of the transistor, the carrier density of the modulation junction is lower than the equilibrium carrier density, and the modulation junction is in the cut-off state; When the sum of positive bias voltage and signal voltage on the modulation pole rises to equal to the transistor threshold voltage, the carrier density of the modulation junction is equal to the equilibrium carrier density, and the transistor is in the critical state of conduction and cutoff; when the sum of positive bias voltage and signal voltage added to the modulation pole rises to above the transistor threshold voltage, the carrier density of the modulation junction is higher than the equilibrium carrier density the transistor is in the on state, the source - channel - drain is connected into a conductive channel, the conductivity of the modulation junction varies exponentially with the difference between the sum of positive bias voltage and signal voltage added to the modulation pole and the threshold voltage of the transistor, and the resistivity and impedance of the modulation junction change with the conductivity, the current flowing through W indirect modulated (MOS) transistors varies with the impedance of the modulation junction. In a circuit composed of supply voltage, load impedance and W indirect modulated (MOS) transistor impedance, the current flowing through the w indirect modulated (MOS) transistor varies with the transistor impedance, which is related to the change of supply voltage and load impedance, so the drain current varies with the difference between the sum of positive bias voltage and signal voltage added to the modulation pole and the threshold voltage of the W indirect modulated (MOS) transistor, complete the conversion and amplification of electrical signal. The above working principle shows that the W indirect modulation (MOS) transistor is operated by two parts, the voltage added to the modulation pole changes the conductivity of the modulation junction, and the resistivity and impedance vary with the conductivity. Therefore, in the circuit composed of supply voltage, load impedance and W indirect modulation (MOS) transistor impedance, the current flowing through the W indirect modulation (MOS) transistor varies with the impedance of the transistor modulation, which is related to the change of supply voltage and load impedance, the voltage added to the modulation pole only changes the conductivity, resistivity and impedance of the modulation junction, so that the current flowing in the W indirect modulation (MOS) transistor changes with the modulation junction impedance to complete the conversion and amplification of the electrical signal.

The modulation pole positive bias voltage and signal voltage of W indirect modulation (MOS) transistor are added to the modulation junction through a low resistance thermistor with positive temperature coefficient. According to the new semiconductor electronic principle, the P-N junction is a variable impedance with adjustable directional conductivity, the thermistor with positive temperature coefficient is in series with a variable impedance, the thermistor is the same temperature as the W indirect modulation (MOS) transistor and the voltage drop varies with the impedance, when the temperature of the W indirect modulation (MOS) transistor rises, the intrinsic carrier density of the modulation junction increases, the threshold voltage decreases, the temperature of the thermistor rises synchronously, the impedance increases, the voltage drops increases, the positive bias voltage and the signal voltage on the W indirect modulation (MOS) transistor modulation junction decrease synchronously, the difference between the sum of the positive bias voltage and the signal voltage added to the modulation junction and the transistor threshold voltage remains constant, the W indirect modulation (MOS) transistor works stably; When the temperature of the W indirect modulation (MOS) transistor decreases, the intrinsic carrier density of the modulation junction decreases, the threshold voltage increases, while the temperature of the thermistor decreases synchronously, the impedance decreases, the voltage drops, the positive bias voltage and the signal voltage increase synchronously on the W indirect modulation (MOS) transistor modulation junction, the difference between the sum of the positive bias voltage and the signal voltage added to the modulation junction and the transistor threshold voltage remains constant without temperature change, the operation and tube temperature stability of the W indirect modulation (MOS) transistor and the power loss of the transistor decrease, it is a semiconductor electronic device with high reliability and low power loss.

Under the new semiconductor electronics principle, W direct modulated transistors, W indirect modulated (MOS) transistors, bipolar junction transistors and unipolar field effect (MOS) transistors operate in two parts, the voltage added to the modulation pole changes the conductivity of the modulation junction, and the resistivity and impedance vary with the conductivity, so that in a circuit composed of supply voltage, load impedance and transistor impedance, the current flowing through the transistor varies with the impedance of the transistor modulation junction, which is related to the change of supply voltage and load impedance, the voltage added to the modulation pole only changes the conductivity, resistivity and impedance of the modulation junction so that the current flowing in the transistor changes with the modulation junction impedance to complete the conversion and amplification of the electrical signal. Therefore, by changing the load impedance, the current flowing in the transistor can be changed so that the voltage on the load impedance changes with the load impedance.

According to the new semiconductor electronics principle, the operation of unipolar field effect (MOS) transistors varies with the difference between the voltage added to the gate and the transistor threshold voltage, and the operation of bipolar junction transistors varies with the difference between the voltage added to the base and the transistor threshold voltage. When the positive bias voltage added to the gate or base is zero, the transistor operates only with the difference between the signal voltage and the threshold voltage, the transistor is in a stop state in static state, and only when the signal voltage rises above the threshold voltage, the transistor is on and working; When the temperature of the transistor rises, the intrinsic carrier density of the modulation junction increases, the threshold voltage decreases, the difference between the signal voltage and the threshold voltage increases, and the width and amplitude of the output signal increase; as the transistor temperature drops, the intrinsic carrier density of the modulation junction decreases, the threshold voltage increases, the difference between the signal voltage and the transistor threshold voltage decreases, the width and amplitude of the output signal decrease, when the signal voltage is very small and below the raised transistor threshold voltage, the transistor will stop working and the transistor temperature changes, making the unipolar field effect (MOS) transistor and the bipolar junction transistor unstable and the output signal distorted.

The operation of W direct-modulated transistor and W indirect-modulated (MOS) transistor varies according to the new semiconductor electronics principle with the difference between the voltage applied to the modulation pole and the transistor threshold voltage. When the positive bias voltage applied to the modulation pole is zero, the transistor operates only with the difference between the signal voltage and the threshold voltage, the static transistor is in a cutoff state, and the transistor is on and working only when the signal voltage added to the modulation junction rises above the threshold voltage; When the temperature of the transistor rises, the intrinsic carrier density of the modulation junction increases, the threshold voltage decreases, and the temperature of the thermistor rises synchronously, the impedance increases, the voltage drop increases, the signal voltage on the transistor modulation junction decreases synchronously, the difference between the signal voltage and the threshold voltage of the transistor remains constant, the W direct modulation transistor and the W indirect modulation (MOS) transistor work stably; When the temperature of W direct modulation transistor or W indirect modulation (MOS) transistor decreases, the intrinsic carrier density of the modulation junction decreases, the threshold voltage increases, and the temperature of the thermistor decreases synchronously, the impedance decreases, the voltage drops, the signal voltage on the W direct modulation transistor or the W indirect modulation (MOS) transistor modulation junction increases synchronously, and the difference between the signal voltage and the transistor threshold voltage remains constant without temperature change, W direct modulation transistors and W indirect modulation (MOS) transistors work stably and output signals do not produce distortion.

W diodes, W direct modulated transistors and W indirect modulated (MOS) transistors correctly and completely perform the functions, characteristics and efficiency of semiconductor electronic devices, and the working rate can be increased by more than 100 times, can maintain normal, stable and reliable operation at ambient temperatures below 80°C, can operate stably without preheating, and electronic devices can improve the ability and speed of processing data with chips with stronger performance, higher stability and reliability, and lower energy loss, effectively solve a series of key problems such as high stability, high reliability, low power loss, high sensitivity, low delay, high fidelity, fever heating, device volume and high power output in emerging fields such as driverless, intelligent medical and artificial intelligence, etc.

Transistor operating state: determined by the difference between the positive bias voltage and the transistor threshold voltage on the W direct modulation transistor modulator, or on the W indirect modulation (MOS) transistor modulator, or on the bipolar junction transistor base, or on the unipolar field effect (MOS) transistor gate, when the positive bias voltage is higher than the transistor threshold voltage V_{b-}>V_{D} at the same time, the carrier density of the modulated junction is higher than equilibrium carrier density n>nn0 the transistor operating in a class A state, when the positive bias voltage is equal to the transistor threshold voltage V_{b-}=V_{D} at the same time, the carrier density of the modulated junction is equal to equilibrium carrier density n=nₙ₀ at the critical point of conduction and cut-off, the transistor operates in class B, and the positive bias voltage is lower than the transistor threshold voltage V_{b-}<V_{D} at the same time, the carrier density of the modulated junction is lower than equilibrium carrier density n< nₙ₀, static modulation junctions in the cutoff state, only when the signal voltage or the sum of the positive bias voltage added to the modulation junction with the signal voltage is higher than the transistor threshold voltage (V_{b}∼ + V_{b-})> V_{d}, the carrier density of the modulation junction is higher than the equilibrium carrier density n > nₙ₀, and the transistor conduction and operation are in the class c (pulse) state. When the difference between the positive bias voltage and the transistor threshold voltage changes, the transistor operating state changes with the change of instability, reduces reliability and increases power loss, increases transistor temperature, increases intrinsic carrier density, decreases the threshold voltage, increases the difference between positive bias voltage and transistor threshold voltage, and further decreases stability and reliability, when a vicious cycle is formed, the elevated transistor temperature will burn out the transistor and electronic equipment.

On the basis of the new semiconductor electronics principle, the operation of transistors varies with the difference between the voltage on the W direct modulation transistor modulation pole, or the W indirect modulation (MOS) transistor modulation pole, or the bipolar junction transistor base, or the unipolar field effect (MOS) transistor gate voltage when the transistor operates in a pulse state, When a positive bias voltage below the transistor threshold voltage is added to the of a W direct-modulated transistor modulator, or to a W indirect-modulated (MOS) transistor modulator, or to a bipolar junction transistor base, or to a unipolar field-effect (MOS) transistor gate, the transistor is still in a cut-off state at a static time, only when the sum of the positive bias voltage and the signal voltage applied to the modulation junction is higher than the transistor threshold voltage (V_{b}∼+V_{b-})>V_{D}, at the same time, the carrier density of the modulated junction is higher than equilibrium carrier density n>nₙ₀, the positive bias voltage becomes the step of the rise of the signal voltage, which can reduce the input signal voltage, reduce the output signal distortion and the switching time of the transistor.

Under the new semiconductor electronics principle, the transistor operating state is determined by the difference between the positive bias voltage and the transistor threshold voltage on the W direct modulation transistor modulation pole, or the W indirect modulation (MOS) transistor modulation pole, or the bipolar junction transistor base, or the unipolar field effect (MOS) transistor gate voltage. The transistor threshold voltage is a function of temperature, decreases with the increase of temperature, and increases with the decrease of temperature, resulting in unstable transistor operating state. The principle of stable transistor operating state is that the transistor threshold voltage does not change with temperature, or the difference between the positive bias voltage and the transistor threshold voltage remains constant without temperature change. One measure that the transistor threshold voltage does not change with temperature is to select semiconductor materials and inclusion materials with the same temperature characteristics, so that the ratio of carrier density of the two materials is close to constant, when the temperature changes, and the transistor threshold voltage does not change with the temperature to ensure the stability of the transistor operating; the difference between the positive bias voltage and the transistor threshold voltage is kept constant without temperature change: Another method is connected in series a negative temperature coefficient thermoelectric element Rₜ in the lower bias circuit of the bipolar junction transistor base or the unipolar field effect (MOS) transistor gate, Fig.4, Fig .5, the thermoelectric module is at the same temperature as the transistor, the voltage drop varies with the impedance of the transistor, the positive bias voltage is equal to the transistor operating voltage, the voltage drop of the thermoelectric module is approximately equal to the transistor threshold voltage at 20°C, and in class A, it is slightly lower than the transistor threshold voltage In class B operating state, it is lower than the transistor threshold voltage In class C operating state; When the temperature of the bipolar junction transistor or the unipolar field effect (MOS) transistor rises, the intrinsic carrier density of the bipolar junction transistor emitter junction or unipolar field effect (MOS) transistor source junction increases, the threshold voltage decreases, while the temperature of the thermoelectric assembly increases synchronously, the impedance decreases, the voltage drops, the positive bias voltage on the bipolar junction transistor base or unipolar field effect (MOS) transistor gate decreases synchronously, and the difference between the positive bias voltage and the transistor threshold voltage remains constant regardless of temperature, bipolar junction transistor and unipolar field effect (MOS) transistor are stable; When the temperature of the bipolar junction transistor or the unipolar field effect (MOS) transistor decreases, the intrinsic carrier density of the bipolar junction transistor emitter junction or unipolar field effect (MOS) transistor source junction decreases, the threshold voltage increases, while the temperature of the thermoelectric assembly decreases synchronously, the impedance increases, the voltage drops increase, the positive bias voltage increases synchronously on the bipolar junction transistor base or unipolar field effect (MOS) transistor gate, and the difference between the positive bias voltage and the transistor threshold voltage remains constant regardless of temperature, bipolar junction transistors and unipolar field effect (MOS) transistors work stably.

The operating state and characteristics of the transistor are determined by the difference between the positive bias voltage and the transistor threshold voltage according to the new semiconductor electronic principle, the transistor threshold voltage is P-N junction built-in voltage, which is determined by the intrinsic carrier density of the semiconductor material and inclusion density, V_{D} = Vₙ-Vₚ = V_{T}In(N_{d}Nₐ/ni²), high density of inclusion and low density of intrinsic carrier, high threshold voltage of transistor, low density of inclusion and high density of intrinsic carrier, low threshold voltage of transistor, transistor with different threshold voltage, operating characteristics, switching speed, data processing capacity and computing efficiency can be made by selecting different semiconductor materials and inclusion density.

The transistor consists of a P-N junction, which is a passive device with directional conductivity adjustable impedance, according to the new semiconductor electronics principle, the W direct modulation transistors, W indirect modulation (MOS) transistors, bipolar junction transistors, and unipolar field effect (MOS) transistors is performed in two parts, the voltage added to the modulation pole, gate or base is only modulated the conductivity of the modulation junction, the resistivity and impedance of the modulation junction vary with the conductivity, the transistor modulation junction is a variable impedance with adjustable conductivity, because the modulation junction impedance is the transistor impedance, the current flowing in the circuit composed of supply voltage, load impedance and transistor impedance varies with the impedance of the modulation junction: I_{D}=E_{C}/(R_{J}+R_{L}), in the formula: I_{D}: drain current, E_{C}: supply voltage, R_{L}: Load impedance (including AC impedance and DC impedance),
R_{J}: transistor impedance: R_{J} = L/nAqµₙ = L/Aqµₙnₙ₀exp[(V_{b}∼+\/_{b-} - V_{D})/V_{T}], L: diffusion length, A: junction cross section area, n: junction carrier density, q: electron charge, µₙ: electron mobility, nn0:equilibrium carrier density, V_{b}~: Input signal voltage, Vb-: bias voltage, V_{D}: threshold voltage, conductivity: σ = nqµₙ = qµₙnₙ₀exp[(V_{b}∼+V_{b-}-V_{D})/V_{T}], resistivity: ρ = 1/nqµₙ = 1/qµₙnₙ₀exp[(\/_{b}∼+\/_{b-}-\/_{D})/V_{T}], by the intrinsic carrier density nn0 and semiconductor materials intrinsic mobility µₙ decision, with the exponential variation of the difference between the sum of the positive bias voltage V_{b-} with the signal voltage V_{b}~ added to the modulation pole and the transistor threshold voltage V_{D}.

The maximum allowable current of the transistor is determined by the cross-sectional area A of the junction, because the transistor impedance decreases with the increase of the voltage added to the modulation pole, the maximum current of the transistor is by the supply voltage E_{C} with load impedance R_{L} comparison decision, I_{Dm}=E_{c}/(R_{L}+Rⱼ)≈E_{C}/R_{L}.

Output power: Pₒ=E_{c}² R_{L}/(R_{J}+R_{L})². As the voltage of the input signal increases, the impedance of the transistor decreases and the current increases. The maximum output power is: Pₒₘ = E_{C}²R_{L}/(R_{L}+R_{J})2 ≈ E_{C}²/R_{L}.

Efficiency: η_{c}=P_{o/}P_{d}=[E_{c}²R_{L}/(R_{J}+R_{L})²]/[E_{c}²/(R_{J}+R_{L})] = R_{L}/(R_{J}+R_{L}), increases with the increase of input signal voltage resulting in the decrease of transistor impedance.

Transistor power loss is the loss of current flowing in the transistor on the transistor impedance, and the P_{C} is a variable with the transistor impedance R_{J},
P_{C} = E_{C}² R_{J}/(R_{J}+R_{L})². In the small signal phase, the square of the drain current I_{D} increment is larger than the decrease of the transistor impedance, and the power loss of the transistor increases with the increase of the input signal voltage, When the transistor impedance decreases to equal to the load impedance, at this time, the square of the drain current I_{D} increment is equal to the decrease of the transistor impedance, and the power loss of the transistor is the largest, and the output power is a quarter of the maximum output power, after the maximum power loss is reached, With the increase of the input signal voltage, the square of the drain current I_{D} increment is less than the decrease of the transistor impedance, and the transistor power loss decreases with the increase of the output power and the decrease of the transistor impedance, that is, when the transistor impedance is equal to the load impedance and the output power is a quarter of the maximum output power, the transistor has the largest power loss, due to the transistor impedance R_{J}=L/nAqµn=L/Aqµₙnₙ₀exp[(V_{b}∼+V_{b-}-V_{D})/V_{T}], static resistance: R_{J0}=L/Aqµₙnₙ₀exp (-V_{D}/ V_{T}),and the threshold voltage V_{D} is fixed for each transistor, the load impedance has been determined at the time of the design circuit, therefore, the selection of positive bias voltage V_{b-} with signal voltage V_{b~} can avoid the maximum power loss point to work, effectively reduce the transistor power loss and reduce the transistor temperature. The above relational quantitative analysis transistor works is used for circuit design and software development.

Conductivity of semiconductor electronic components: σ=nqµₙ=qµₙnₙ₀ exp[(V_{b}∼+V_{b-}-V_{D})/V_{T}], and resistivity: ρ=1/nqµₙ=1/qµₙnⁿ⁰exp[(V_{b}∼+V_{b-}-V_{D})/V_{T}], according to new semiconductor electronic principles, static conductivity: determined by intrinsic carrier density nn0 and intrinsic mobility µ_{η}, because transistors can be made of a variety of semiconductor materials, the static conductivity and resistivity of different semiconductor materials are different. Different semiconductor materials can be used to manufacture transistors with different functions and characteristics.

The intrinsic carrier density of silicon is 1.5×10¹⁰, intrinsic mobility: electron 1350/cm², hole 480/cm², the threshold voltage of the silicon transistor is about 0.6 V; and the intrinsic carrier density of germanium is 2.5×10¹³, intrinsic mobility: electron 3900/ cm², hole 1900/ cm², the threshold voltage of germanium transistor is about 0.25V. The data show that the static conductivity of germanium is three orders of magnitude higher than that of silicon, and the static resistivity of germanium is three orders of magnitude lower than that of silicon. Therefore, germanium transistor has high conductivity and threshold voltage is only 1/3 of silicon transistor, for the same working state, the positive bias voltage and switching time of transistor are reduced by 2/3, thus increasing the switching speed of transistor and reducing the power loss of transistor. Therefore, semiconductor electronic devices made of germanium, a semiconductor material with high static conductivity and low static resistivity, have better functions and characteristics than semiconductor electronic devices made of silicon materials. It has been proved that according to the principle of new semiconductor electronics, semiconductor electronic devices with higher manufacturing functions and characteristics can be expanded.

According to the principle of new semiconductor electronics, the work of semiconductor electronics composed of single or combined junctions is to change the carrier density distribution of the junction, to modulate the conductivity of semiconductor electronic devices, and to complete the conversion and amplification of electrical signals. The work of semiconductor electronic devices is that the change of carrier density distribution changes the conductivity, not emits electrons and does not produce current, so semiconductor electronic devices will not fail and aging. Thus, the qualified rate and service life of semiconductor electronic devices and products are improved, and the production cost and usage fee are reduced.

Software is developed according to the working principle, structure, characteristics, function, relationship with external stress, relationships, circuit structure, and functions to be completed, for operation and control hardware, new semiconductor electronic principle, technology, passive semiconductor devices, new relationships and circuit structure in all semiconductor electronic technology and equipment, is the fundamental change of hardware, therefore, new semiconductor electronic principle, technology, passive semiconductor devices, new relationships and circuit structure, is the basis for the development of new code, software and operating system.

Compared with existing technologies:
The invention is a fundamental change of semiconductor principles and technology, revealing that the function of semiconductor electronic devices is to convert electrical signals, the conversion of electrical signals is accomplished by modulating the conductivity of semiconductor electronic devices, conductivity modulation is the basis of semiconductor electronic devices and technologies. New semiconductor electronic principles, technologies, passive semiconductor electronic devices, new software, and operating systems based on conductivity change, replacing current semiconductor electronic principles, technologies, active semiconductor electronic devices, software, and operating systems based on current change for applications in all semiconductor electronic devices.

Current is the continuous movement of electrons under external force, and the dependent variable with the applied voltage, the electrical conductivity of electronic devices and the loop impedance. Current is a phenomenon, not the essential characteristic of matter. The injection current can only increase the number of moving electrons by the same amount, cannot produce current and make current mutation, because there is no mechanism to make current generation and mutation. Therefore, the current semiconductor electronic principle and technology based on current change cannot correctly reflect the conductive mechanism and working principle of semiconductor electronic devices, and cannot effectively solve a series of key problems such as heating in semiconductor theory and technology. Conductivity is the basic characteristic of matter, which represents the conductivity of matter. It is determined by the free carrier density of matter. The carrier density difference forms junction and built-in electric field. Semiconductor electronic devices composed of junctions change the carrier density distribution of junctions by applied voltage, modulate the conductivity of semiconductor electronic devices, and complete the conversion and amplification of electrical signals. As a result, the new semiconductor electronic principles and technologies based on the change of conductivity reflect correctly the conductive mechanism and working principle of semiconductor electronic devices in essence, reveal the structure and variation of semiconductor electronic devices with applied stress, unify the function, working principle and the mechanism of modulating semiconductor conductivity of semiconductor electronic devices, and give full play to the functions, characteristics and efficiency of semiconductor electronic devices correctly and completely. Semiconductor electronic devices can select different semiconductor materials according to their functions and characteristics, and the working rate can be increased by more than 100 times, and they can work normally, stably and reliably at ambient temperatures below 80°C, Without preheating, starting up can work stably, improve the qualified rate and service life of semiconductor electronic devices and products, reduce production cost and usage fee, electronic devices with stronger performance, higher stability and reliability, lower energy loss chip, improve the ability and speed of processing data, effectively solve a series of key problems of semiconductor theory and technology such as high stability, high reliability, heating, low power loss, high sensitivity, low delay, volume of devices and high power output in emerging fields such as driverless, intelligent medical and artificial intelligence. New semiconductor electronic principles and technologies are fundamental changes in semiconductor science and technology. New software and new operating systems developed according to new semiconductor electronic principles and technologies will vigorously promote the wider application and rapid development of semiconductor science and technology, drive all science and technology development and social progress.

### Instructions with drawings

Fig 1 is a W diode circuit diagram: The low resistance thermistor Rₜ connected in series with a positive temperature coefficient on the P-N junction or semiconductor metal junction, the working voltage E_{c} is added to the W diode through the thermistor, and the thermistor is at the same temperature as the W diode.
Fig 2 shows the circuit diagram of W direct modulation transistor: the modulation pole M is with a low resistance thermistor Rₜ with a positive temperature coefficient. In series, the reverse bias voltage E_{c} is added to drain, and the positive bias voltage and the signal voltage are added to the modulation pole through the low resistance thermistor of the positive temperature coefficient, and the thermistor is at the same temperature as the W direct modulation transistor.
Fig 3 shows the circuit diagram of W indirect modulation (MOS) transistor: the low resistance thermistor Rₜ with a positive temperature coefficient. In series, the reverse bias voltage E_{c} is added to the drain, and the positive bias voltage and the signal voltage are added to the modulation pole through the low resistance thermistor of the positive temperature coefficient, and the thermistor is at the same temperature as the W indirect modulation (MOS) transistor.
Fig 4 is a circuit diagram of a bipolar junction transistor: In the down bias circuit of the positive bias voltage circuit of the base, a thermoelectric component Rₜ a negative temperature coefficient is connected in series at the base and at the collector added voltage E_{c}, and the thermoelectric is at the same temperature as the transistor.
Fig 5 shows the circuit diagram of a unipolar field-effect (MOS) transistor. In the down bias circuit of the positive bias voltage circuit of the gate, a thermoelectric module Rₜ with negative temperature coefficient is connected in series, the reverse bias voltage E_{c} is added to the drain and the positive bias voltage and the signal voltage are added to the gate, and the thermoelectric is at the same temperature as the transistor.

## Claims

1. New semiconductor electronic principles technologies and devices are fundamental changes in semiconductor electronic science and technology, characterized are: New semiconductor electronic principles based on changes in conductivity, revealing that the function of semiconductor electronic devices is to convert electrical signals, which are converted by the voltages applied to junctions, P-N junctions, semiconductor metal junctions or insulator metal junctions that can be formed in a variety of semiconductor materials, changing the carrier density distribution on both sides of and junctions, the conductivity and resistivity of modulated junction, the exponential variation of the conductivity of the passive semiconductor electronic devices formed by the junction alone or in combination with the difference between the applied voltage and the transistor threshold voltage, and modulating the conductivity of the semiconductor electronic devices and completing the conversion of electrical signals; New semiconductor electronic principles, technologies, passive semiconductor electronic devices, software and operating systems based on conductivity change, replacing current semiconductor electronic principles, technologies, active semiconductor electronic devices, current software and operating systems for all semiconductor electronic technologies and devices based on current change; A new semiconductor electronic device with high stability, reliability and low power loss is invented to effectively solve the key problems such as heating of semiconductor electronic devices; Conductivity is the basic characteristic of matter, which indicates the conductivity of matter, which is determined by the free carrier density of matter, the conductivity of semiconductor is between conductor and insulator, wide conductivity modulation area, and is the best material for manufacturing electronic devices; The conductivity of pure semiconductor and uniform free carrier density semiconductor cannot be modulated because there is no mechanism to modulate conductivity; By doping on a semiconductor substrate, two regions with different carrier density, or electromagnetic fields, are formed, changing the carrier density distribution in the semiconductor, forming two regions with different carrier density, or semiconductor contact with metal, forming two regions with different carrier density, or insulator contact with metal, forming two regions with different carrier density, when two different regions of carrier density are connected, the carrier density is different, the majority carrier diffuses to the minority carrier region, the carrier density distributes according to the exponential law and forms the junction built-in voltage, the carrier density and junction built-in voltage are interdependent exponential relationships, at the junction of the positive and negative charge region, the positive charge carrier density is equal to the negative charge carrier density, and the free carrier density is zero, forming a junction with very low conductivity, high resistivity and electric neutrality, when a voltage is added to the positive and negative charge region, the carrier density distribution on both sides of the junction and the junction varies exponentially with the difference between the applied voltage and the junction built-in voltage, when there is a small change in the applied voltage on the junction, the carrier density on both sides of the junction and the junction to the exponential law, so by changing the voltage added to the positive and negative charge region, change the carrier density on both sides of the junction and the junction, the conductivity and resistivity of the modulation junction, the junction formed in the semiconductor, with the function of modulating the conductivity of the semiconductor, is the mechanism of modulating the conductivity of the semiconductor, P-N the junction is a typical; When a P-N junction is formed on a semiconductor substrate, a positive bias voltage is added to the P-N junction higher than the built-in voltage, the carrier density of the P-N junction is higher than the equilibrium carrier density, the P-N junction conduction, the voltage is called threshold voltage, the carrier density of the P-N junction varies exponentially with the difference between the applied voltage and the threshold voltage, the conductivity and resistivity of the P-N junction vary with the carrier density, the conductivity and resistivity of the P-N junction change exponentially with the difference between the voltage on the P-N junction and the threshold voltage, and the current flowing through the P-N junction changes with the P-N junction impedance; The P-N junction is composed of P-type, N-type and electrically neutral junctions, and is a variable impedance with directional adjustable conductivity, since the applied voltage only changes the carrier density distribution and conductivity of the p-n junction, p-n junction does not generate current and is therefore a passive element; P-N junction built-in voltage is the threshold voltage of the P-N junction, when the positive bias voltage added to the P-N junction is lower than the threshold voltage, the carrier density of the P-N junction is lower than the equilibrium carrier density, the P-N junction is the cutoff state, when the reverse bias voltage is added to the P-N junction, the P-N junction is a cutoff state, when the reverse bias voltage is twice higher than the threshold voltage, the P-N junction is reversed and the reverse current is flowing through in the P-N junction; The transistor threshold voltage is formed by the diffusion of the majority carrier to the minority carrier region, It is the difference of carrier density, which is determined by the intrinsic carrier density and the doping density of the semiconductor material, the intrinsic carrier density is a function of temperature, increases with temperature and decreases with temperature, therefore, the transistor threshold voltage is a function of temperature, decreases with the increases of temperature, and increases with the decreases of temperature, When the transistor temperature rises, the intrinsic carrier density increases, the threshold voltage decreases, the difference between the positive bias voltage and the transistor threshold voltage increases, the junction carrier density increases, the conductivity increases and the resistivity decreases, the junction impedance decreases, the current over the junction increases, the transistor operating characteristics change, instability and reliability decrease, when a vicious cycle is formed, the elevated transistor temperature will burn out transistors and electronic equipment, when the transistor temperature drops, the intrinsic carrier density decreases, the threshold voltage rises, the difference between the positive bias voltage and the transistor threshold voltage decreases, the junction carrier density decreases, the conductivity decreases and the resistivity increases, the junction impedance increases and the current flows through the junction decreases, the transistor operating characteristics are changed, resulting in instability and reduced reliability, when the transistor threshold voltage rises above the positive bias voltage, the junction carrier density is lower than the equilibrium carrier density, the transistor is in a cut-off state, and in serious cases the transistor will stop working, the temperature variation of the transistor threshold voltage, determined by the intrinsic carrier density and the impurity density of the semiconductor material, is the fundamental reason for the instability and reliability of the transistor; The functions of semiconductor electronic devices are to convert electrical signals, applying the new principle of semiconductor electronics based on changes in conductivity, electromagnetic fields changing the carrier density distribution of semiconductors to form regions with different carrier density and conductivity, forming junctions in semiconductors with the function of modulating semiconductor conductivity, P-N junctions being a passive element with directional conductivity adjustable impedance variable, conductivity and resistivity of P-N junctions being exponential with the difference between the voltage applied to the P-N junction and the threshold voltage as a function of temperature, a junction, P-N junction or semiconductor metal junction that can be formed in a variety of semiconductor materials, individually or in combination into passive semiconductor electronic devices, and a passive transistor with high stability, high reliability, fast switching speed and low power loss for all semiconductor electronic devices; A junction formed in semiconductors, or in semiconductor contact with metal, or in insulator contact with metal, having the function of modulating electrical conductivity, for the composition of electronic devices for conversion of electrical signals and photoelectric, con operating on the principles and characteristics of junctions and for use in electronic devices; High stability, reliability and low power loss semiconductor electronic devices: W diodes: low resistance thermistors connected in series with a positive temperature coefficient on P-N junction or semiconductor metal junction, Fig 1, the working voltage is added to the W diode through a thermistor, the thermistor is at the same temperature as the W diode, according to the new semiconductor electronic principle, the P-N junction is a variable impedance with adjustable directional conductivity, the thermistor is in series with a variable impedance, the same temperature as the W diode, and the voltage drop of the thermistor varies with temperature and impedance, the positive bias voltage is added to the W diode, When the positive bias voltage is higher than the W diode threshold voltage, the junction carrier density of the W diode is higher than the equilibrium carrier density, the conductivity and resistivity of the W diode change exponentially with the difference between the voltage added to the W diode and the threshold voltage, the current flowing through the W diode changes with the junction impedance to complete the electrical signal conversion, when the positive bias voltage added to the W diode is lower than the W diode threshold voltage, the junction carrier density of the W diode is lower than the equilibrium carrier density, and the W diode is in cutoff state, when the reverse bias voltage is added to the W diode, the W diode is cut-off state, when the reverse bias voltage added to the W diode is double the threshold
voltage, the diode is reversed and produces reverse current, when the temperature of the W diode rises, the intrinsic carrier density increases and the threshold voltage decreases, the temperature of the positive temperature coefficient thermistor connected in series with the W diode at the same temperature increases synchronously, the resistance value increases, the voltage drop increases, the positive bias voltage added to the W diode decreases synchronously, the difference between the positive bias voltage and the W diode threshold voltage remains constant, the W diode works stably, when the W diode temperature drops, the intrinsic carrier density decreases, the threshold voltage increases, and the temperature of the positive temperature coefficient thermistor decreases synchronously with the W diode temperature, the resistance value decreases, the voltage drops, the positive bias voltage added to the W diode increases synchronously, the difference between the positive bias voltage and the W diode threshold voltage remains constant without temperature change, W diode operation and tube temperature stability, transistor power loss is reduced, is a high reliability and low power loss semiconductor electronic devices; WTriode Transistor: according to the conductivity is directly modulated by the voltage added to the modulation pole, or by the voltage added to the modulation pole, change the carrier density distribution in the channel indirect modulation, divided into w direct modulation transistor and W indirect modulation transistor; W direct modulation transistors: W direct modulation transistors are composed of two P-N junctions in reverse series, the two P-N junctions are the modulation junction at the source end and the drain junction at the drain end, and the modulation pole between the modulation junction and the drain junction, the modulation pole is connected with a low resistance thermistor with a positive temperature coefficient, Fig 2, the principle of W direct modulation transistor is that one of the two P-N junctions in reverse series is always reverse bias and the transistor is in the cutoff state in static, the reverse bias voltage is added to the drain and the positive bias voltage through the thermistor is added to the modulation pole, according to the working principle of the P-N junction, when the positive bias voltage added to the modulation junction is higher than the threshold voltage, the modulation junction of the transistor is on-state, so the reverse bias voltage added to the drain of the W direct modulation transistor makes the drain junction reverse, w direct modulation transistor changes from two P-N junctions in reverse series to two P-N junctions in forward series, the drain junction of the w direct modulation transistor becomes positive bias after being reversed, the conductivity of the positive bias drain junction is very high and the resistivity is very low, and the drain junction after the reverse type becomes a thoroughfare that allowing large current to pass through, the operates of transistor is determined only by the difference between the voltage added to the modulation junction and the transistor threshold voltage, and varies with the modulation junction impedance, according to the P-N junction is a variable impedance with directional conductivity adjustable, and the modulation junction is a P-N junction, so when the voltage added to the modulation junction has a small change, the carrier density of the modulation junction varies exponentially with the difference between the voltage added to the modulation junction and the transistor threshold voltage, the conductivity of the modulation junction changes exponentially, the resistivity and impedance of the modulation junction vary with the conductivity, and the current flowing through the transistor changes with the modulation junction impedance, in a circuit composed of supply voltage, load impedance and transistor impedance, the current flowing through the transistor changes with the difference between the voltage added to the modulation junction and threshold voltage of the transistor, the resistivity and impedance of the modulation junction vary with the conductivity, and the current flowing through the transistor changes with the modulation junction impedance, which is related to the change of the supply voltage and the load impedance, and completes the amplification and conversion of the electrical signal, the above working principle shows that, the W direct modulation transistor works in two parts, the voltage applied to the modulation pole changes the conductivity of the modulation junction, and the resistivity and impedance change with the conductivity, thus, in a circuit composed of supply voltage, load impedance and W direct modulation transistor impedance, the current flowing through the W direct modulation transistor varies with the impedance of the transistor modulation junction, which is related to the change of supply voltage and load impedance, therefore, the voltage applied to the modulation pole only changes the conductivity, resistivity and impedance of the modulation junction, so that the current flowing in the W direct modulation transistor changes with the modulation junction impedance, completes the conversion and amplification of electrical signals, and the positive bias voltage and signal voltage of the W direct modulation transistor modulation pole are added to the modulation junction through a low resistance thermistor Rt with positive temperature coefficient, according to the new semiconductor electronic principle, the P-N junction is a variable impedance with adjustable directional conductivity, the thermistor with positive temperature coefficient is connected with a variable impedance in series with W directly modulated transistor, the voltage drop of the thermistor varies with temperature and impedance, when the temperature of the W direct modulation transistor rises, the intrinsic carrier density of the modulation junction increases, the threshold voltage decreases, and the temperature of the thermistor rises synchronously, the impedance increases and the voltage drop increases, the positive bias voltage and signal voltage on the W direct modulation transistor modulation junction decrease synchronously, and the difference between the sun of positive bias voltage with the signal voltage added to the modulation junction and the transistor threshold voltage remains constant, the W direct modulation transistor works stably, when the temperature of the W direct modulation transistor decreases, the modulation junction intrinsic carrier density decreases, the threshold voltage increases, while the temperature of the positive temperature coefficient thermistor decreases synchronously, the impedance decreases and the voltage drops, the positive bias voltage and signal voltage on the W direct modulation transistor modulation junction increase synchronously, the difference between the sun of positive bias voltage with the signal voltage added to the modulation junction and the transistor threshold voltage remains constant without temperature change, the operation of the W direct modulation transistor and the tube temperature stability, and the transistor power loss decreases; W Indirect Modulation (MOS) Transistor: W indirectness modulation (MOS) transistors are divided into P-W-indirectness modulation (MOS) transistors and N-W-indirectness modulation (MOS) transistors according to whether the semiconductor substrate is P- or N-type, the P type W indirect modulation (MOS) transistor works exactly the same as the N type W indirect modulation (MOS) transistor, the P type W indirect modulation (MOS) transistor diffuses two highly doped N regions on the P semiconductor substrate, leading the electrode into source and drain electrodes, the two N regions form two reverse series P-N junctions, which are the modulation junction at the source end and the drain junction at the drain end, respectively, a thin oxide layer is grown on the substrate surface, and a metal layer is deposited on the oxide layer, connecting a low resistance thermistor Rt with positive temperature coefficient, leading the electrode to become the modulation electrode, Fig.3; The principle of P W indirect modulation (MOS) transistors is that when the modulation pole does not add a positive bias voltage, one of the two reverse series P-N junctions on the source-channel-drain channel is always reverse bias, and the W indirect modulation (MOS) transistor is in a cutoff state, when the drain plus the reverse bias voltage and the modulation pole plus the positive bias voltage, the positive bias voltage added to the modulation pole induces the electronic charge at the oxide boundary in the P channel, which changes the carrier density distribution in the P region and forms the N-type conductive region, a new P-N junction and the establishment of an electric field are formed by the diffusion of most carriers in the P-type and N-type conductive regions, the field voltage is positively applied to the modulation junction, the electron concentration, field voltage and conductivity of the N conduction region increase with the increase of the positive bias voltage., the carrier density of the modulation junction increases with the decrease of the difference between the field voltage and the threshold voltage, when the carrier density of the modulation junction increases to equal or higher than the equilibrium carrier density, the field voltage rises to equal to or higher than the threshold voltage, the transistor modulation junction is on-state, the reverse bias voltage added to the W indirect modulation (MOS) transistor drain makes the drain junction reverse, the W indirect modulation (MOS) transistor changes from two reverse series P-N junction to two forward series P-N junction, the drain junction of the W indirect modulation (MOS) transistor becomes positive bias after being reversed, the conductivity of the positive bias drain junction is very high and the resistivity is very low, and the drain junction becomes a thoroughfare that allows a large current to pass through after the reverse-type, the operation of the transistor is determined only by the difference between the sum of positive bias voltage and signal voltage added to the modulation junction and the threshold voltage of the transistor, and varies with the modulation junction impedance; According to the P-N junction is a variable impedance with directional conductivity adjustable, when the voltage added to the modulation junction is lower than the threshold voltage of the modulation junction, the carrier density of the modulation junction is lower than the equilibrium carrier density, the modulation junction is in the cutoff state, when the voltage added to the modulation junction rises to equal to the modulation threshold voltage, the carrier density of the modulation junction is equal to the equilibrium carrier density, the modulation junction is in the critical state of conduction and cutoff, when the voltage added to the modulation junction rises above the modulation threshold voltage, the carrier density of the modulation junction is higher than the equilibrium carrier density, and the modulation junction is in the conduction state, the conductivity of the modulation junction varies exponentially with the sum of the positive bias voltage and the signal voltage added to the modulation junction and the threshold voltage of the W indirect modulation (MOS) transistor, the resistivity and impedance of the modulation junction vary with the conductivity, and the current flowing through the W indirect modulation (MOS) transistor varies with the impedance of the modulation junction, in a circuit composed of supply voltage, load impedance and W indirect modulation (MOS) transistor impedance, the current flowing through the W indirect modulated (MOS) transistor varies with the impedance of the transistor and is related to the change of the supply voltage and the load impedance, so the drain current changes with the difference between the sum of the positive bias voltage and the signal voltage on the modulation junction and the threshold voltage of the W indirect modulated (MOS) transistor to complete the conversion and amplification of the electrical signal, the above working principle shows that the operation of the W indirect modulated (MOS) transistor is completed by two parts, and the voltage added to the modulation pole changes the conductivity of the modulation junction, resistivity and impedance change with conductivity, so in a circuit composed of supply voltage, load impedance and W indirect modulation (MOS) transistor impedance, the current flowing through the W indirect modulation (MOS) transistor varies with the impedance of the transistor modulation junction, the voltage applied to the modulation pole only changes the conductivity, resistivity and impedance of the modulation junction, so that the current flowing in the W indirect modulation (MOS) transistor changes with the modulation junction impedance, completes the conversion and amplification of the electrical signal, the modulation pole voltage of the W indirect modulation (MOS) transistor is added to the modulation junction through a low resistance value of a thermistor with positive temperature coefficient, according to the new semiconductor electronic principle, the P-N junction is a variable impedance with directional conductivity adjustable, the thermistor with positive temperature coefficient is in series with a variable impedance, the thermistor is the same temperature as the W indirect modulation (MOS) transistor, and the voltage drop varies with the impedance, when the temperature of the W indirect modulation (MOS) transistor rises, the intrinsic carrier density of the modulation junction increases, the threshold voltage decreases, and the temperature of the thermistor rises synchronously, the impedance increases, the voltage drop increases, and the voltage on the W indirect modulation (MOS) transistor modulation junction decreases synchronously, the difference between the voltage added to the modulation junction and the transistor threshold voltage remains constant without temperature change, the operation of the W indirect modulation (MOS) transistor is stable, when the temperature of the W indirect modulation (MOS) transistor decreases, the intrinsic carrier density of the modulation junction decreases and the threshold voltage increases, while the temperature of the thermistor decreases, the impedance decreases, the voltage drops, and the voltage synchronously increases on the W indirect modulation (MOS) transistor modulation junction, the difference between the voltage added to the modulation junction and the threshold voltage of the transistor is kept as a constant which does not change with the temperature, the operation of the W indirect modulation (MOS) transistor and the stability of the tube temperature, the power loss of the transistor is reduced, it is a semiconductor electronic device with high reliability and low power loss; Under the new semiconductor electronics principle, W direct modulated transistors, W indirect modulated (MOS) transistors, bipolar junction transistors, and unipolar field effect (MOS) transistors operate in two parts, the voltage applied to the modulation pole changes the conductivity of the modulation junction, and the resistivity and impedance vary with the conductivity, so that the current flowing through the transistor in the circuit composed of the supply voltage, the load impedance and the transistor impedance changes with the impedance of the transistor modulation junction, which is related to the change of the supply voltage and the load impedance, the voltage added to the modulation pole only changes the conductivity, resistivity and impedance of the modulation junction so that the current flowing in the transistor changes with the modulation junction impedance to complete the conversion and amplification of the electrical signal, therefore, by changing the load impedance, the current flowing in the transistor can be changed, so that the voltage on the load impedance changes with the load impedance; W direct modulated transistors and W indirect modulated (MOS) transistors operate with the difference between the voltage added to the modulation pole and the transistor threshold voltage, when the positive bias voltage added to the modulation pole is zero (pulse state), the transistor operates changes only with the difference between the signal voltage and the threshold voltage, and the transistor is in a stop state at static time, the transistor is on and working only when the signal voltage added to the modulation junction rises above the threshold voltage, when the transistor temperature rises, the intrinsic carrier density of the modulation junction increases and the threshold voltage decreases, while the temperature of the thermistor rises synchronously, the impedance increases, the voltage drops increases, the signal voltage added to the transistor modulation junction decreases synchronously, the difference between the signal voltage and the transistor threshold voltage remains constant, the W direct modulation transistor and the W indirect modulation (MOS) transistor operate stably, when the temperature of the W direct modulation transistor or the W indirect modulation (MOS) transistor drops, the intrinsic carrier density of the modulation junction decreases, the threshold voltage increases, and the temperature of the thermistor decreases synchronously, the impedance decreases, the voltage drop decreases, the signal voltage on the W direct modulation transistor or the W indirect modulation (MOS) transistor modulation junction increases synchronously, the difference between the signal voltage and the transistor threshold voltage remains constant without temperature change, the W direct modulation transistor and the W indirect modulation (MOS) transistor work stably, and the output signal does not produce distortion; W diodes, W direct modulated transistors and W indirect modulated (MOS) transistors correctly and completely perform the functions, characteristics and efficiency of semiconductor electronic devices, and the working rate can be increased by more than 100 times, can maintain normal, stable and reliable operation at ambient temperatures below 80°C, can operate stably without preheating, and electronic devices can improve the ability and speed of processing data with chips with stronger performance, higher stability and reliability, and lower energy loss, effectively solve a series of key problems such as high stability, high reliability, low power loss, high sensitivity, low delay, heating, device volume and high power output in emerging fields such as driverless, intelligent medical and artificial intelligence; Transistor operating state: determined by the difference between the positive bias voltage and the transistor threshold voltage on the W direct modulation transistor modulation junction, or on the W indirect modulation (MOS) transistor modulation junction, or on the bipolar junction transistor base, or on the unipolar field effect (MOS) transistor gate, when the positive bias voltage is higher than the transistor threshold voltage V_{b}->V_{D} at the same time, the carrier density of the modulate junction is higher than equilibrium carrier density n>nn0, transistor operates in a class A state, when the positive bias voltage is equal to transistor threshold voltage V_{b}-=V_{D} at the same time, the carrier density of the modulate junction is equal to equilibrium carrier density n=nn0 at the critical point of conduction and cutoff, the transistor operates in class B state, when the positive bias voltage is lower than transistor threshold voltage Vb-<VD at the same time, the carrier density of the modulate junction is lower than equilibrium carrier density n<nₙ₀, static modulation junctions in the cutoff state, only when the signal voltage or the sum of the positive bias voltage added to the modulation junction with the signal voltage is higher than the transistor threshold voltage (V_{b}∼ + V_{b-})> V_{d}, the carrier density of the modulation junction is higher than the equilibrium carrier density n > nₙ₀, and the transistor conduction and operation are in the class c (pulse) state, When the difference between the positive bias voltage and the transistor threshold voltage changes, the transistor operating state changes with the change of instability, reduces reliability and increases power loss, increases transistor temperature, increases intrinsic carrier density, decreases the threshold voltage, increases the difference between positive bias voltage and transistor threshold voltage, and further decreases stability and reliability, when a vicious cycle is formed, the elevated transistor temperature will burn out the transistor and electronic equipment; On the basis of the new semiconductor electronics principle, the operation of transistors varies with the difference between the voltage on the W direct modulation transistor modulation pole, or the W indirect modulation (MOS) transistor modulation pole, or the bipolar junction transistor base pole, or the unipolar field effect (MOS) transistor gate voltage, when the transistor operates in a pulse state, when a positive bias voltage lower than the transistor threshold voltage is added to the modulator of a W direct-modulation transistor, or to a W indirect-modulated (MOS) transistor modulator, or to a bipolar junction transistor base, or to a unipolar field-effect (MOS) transistor gate, the transistor is still in a cut-off state at static, when the sum of the positive bias voltage applied to the modulation junction and the signal voltage is higher than the transistor threshold voltage, the (V_{b}∼+V_{b-} )>V_{D}, at the same time, the carrier density of the modulation junction is higher than equilibrium carrier density n>nₙ₀, the positive bias voltage becomes the step of the rise of the signal voltage, which can reduce the input signal voltage, reduce the output signal distortion and the switching time of the transistor; Under the new semiconductor electronics principle, the transistor operating state is determined by the difference between the positive bias voltage and the transistor threshold voltage on the W direct modulation transistor modulation pole, or the W indirect modulation (MOS) transistor modulation pole, or the bipolar junction transistor base pole, or the unipolar field effect (MOS) transistor gate voltage, the transistor threshold voltage is a function of temperature, decreases with the increase of temperature, and increases with the decrease of temperature, resulting in unstable transistor operating state, the principle of stable transistor operating state is that the transistor threshold voltage does not change with temperature, or the difference between the positive bias voltage and the transistor threshold voltage is maintained as a constant that does not change with temperature, a measure by which the transistor threshold voltage does not change with temperature is to select semiconductor and hybrid materials with the same temperature characteristics so that the ratio of carrier density between the two materials remains close to constant at temperature, the transistor threshold voltage does not change with temperature, and the transistor operates stably, another method is to keep the difference between the positive bias voltage and the transistor threshold voltage constant without temperature, in the lower bias circuit of the positive bias voltage circuit of the bipolar junction transistor base or unipolor field effect (MOS) transistor gate, a thermoelectric element Rt with negative temperature coefficient is connected in series, Fig 4, Fig 5, thermoelectric elements are at the same temperature as transistors, voltage drop varies with impedance, positive bias voltage is equal to transistor operating voltage, thermoelectric elements voltage drop at 20°C, in class A operating state is approximately equal to transistor threshold voltage, in class B operating state is slightly lower than transistor threshold voltage, in class C operating state is lower than transistor threshold voltage, when bipolar junction transistor or unipolar field effect (MOS) transistor temperature rises, the intrinsic carrier density of bipolar junction transistor emitter junction or unipolar field effect (MOS) transistor source junction increases and threshold voltage decreases, while the temperature of the thermoelectric element increases synchronously, the impedance decreases, the voltage drops, the positive bias voltage added to the bipolar junction transistor base or unipolar field effect (MOS) transistor gate decreases synchronously, the difference between the positive bias voltage and the transistor threshold voltage remains constant, the bipolar junction transistor and the unipolar field effect (MOS) transistor are stable, and the carrier density of the bipolar junction transistor emitter junction or the unipolar field effect (MOS) transistor source junction decreases when the temperature of the bipolar junction transistor or unipolar field effect (MOS) transistor drops, the threshold voltage increases, while the temperature of the thermoelectric element decreases synchronously, the impedance increases, the voltage drops increase, the positive bias voltage added to the bipolar junction transistor base or unipolar field effect (MOS) transistor gate increases synchronously, the difference between the positive bias voltage and the transistor threshold voltage remains constant without temperature change, the bipolar junction transistor and the unipolar field effect (MOS) transistor operate stably; The operating state and characteristics of the transistor are determined by the difference between the positive bias voltage and the transistor threshold voltage according to the new semiconductor electronic principle, the transistor threshold voltage is P-N junction built-in voltage, which is determined by the intrinsic carrier density of the semiconductor material and inclusion density, V_{D} = Vₙ-Vₚ = V_{T}In(N_{d}N_{a/}ni²), high density of inclusion and low density of intrinsic carrier, high threshold voltage of transistor, low density of inclusion and high density of intrinsic carrier, low threshold voltage of transistor, transistor with different threshold voltage, operating characteristics, switching speed, data processing capacity and computing efficiency can be made by selecting different semiconductor materials and inclusion density; The transistor consists of a P-N junction, which is a passive device with directional conductivity adjustable impedance, according to the new semiconductor electronics principle, the W direct modulation transistors, W indirect modulation (MOS) transistors, bipolar junction transistors, and unipolar field effect (MOS) transistors is performed in two parts, the voltage added to the modulation pole, gate or base is only modulated the conductivity of the modulation junction, the resistivity and impedance of the modulation junction vary with the conductivity, the transistor modulation junction is a variable impedance with adjustable conductivity, because the modulation junction impedance is the transistor impedance, the current flowing in the circuit composed of supply voltage, load impedance and transistor impedance varies with the impedance of the modulation junction: I_{D}=E_{C}/(R_{J}+R_{L}), in the formula: I_{D}: drain current, EC: supply voltage, R_{L}: load impedance (including AC impedance and DC impedance),R_{J}: transistor impedance: R_{J} = L/nAqµₙ = L/Aqµₙnₙ₀exp[(V_{b}∼+V_{b-} - V_{D})/V_{T}], L: diffusion length, A: junction cross section area, n: junction carrier density, q: electron charge, µₙ: electron mobility, nₙ₀: equilibrium carrier density, V_{b}^{∼}:Input signal voltage, V_{b-}:bias voltage, V_{D}: threshold voltage, conductivity:
σ = nqµₙ = qµₙnₙ₀exp[(V_{b}∼+V_{b-}-V_{D})/V_{T}], resistivity: ρ = 1/nqµₙ = 1/qµₙnₙ₀exp[(V_{b}∼+V_{b-}-V_{D})/V_{T}], by the intrinsic carrier density nₙ₀ and semiconductor materials intrinsic mobility µₙ decision, with the exponential variation of the difference between the sum of the positive bias voltage V_{b-} with the signal voltage V_{b}~ added to the modulation pole and the transistor threshold voltage V_{D}; The maximum allowable current of the transistor is determined by the cross sectional area A of the junction, because the transistor impedance decreases with the increase of the voltage added to the modulation pole, the maximum current of the transistor is by the supply voltage E_{C} with load impedance R_{L} comparison decision, I_{Dm}=E_{c}/(R_{L}+Rⱼ)≈E_{C}/R_{L}; Output power: Pₒ=E_{c}² R_{L}(R_{J}+R_{L)}²,as the voltage of the input signal increases, the impedance of the transistor decreases and the current increases, the maximum output power is: Pₒₘ = E_{C}²R_{L}(R_{L}+R_{J})2 ≈ E_{C}²/R_{L}; Efficiency: η_{c}=Pₒ/P_{d}=[Ec²R_{L}/(R_{J}+R_{L})²]/[E_{c}²/(R_{J}+R_{L})] = R_{L}/(R_{L}+R_{L}), increases with the increase of input signal voltage resulting in the decrease of transistor impedance; Transistor power loss is the loss of current flowing in the transistor on the transistor impedance, and the Pc is a variable with the transistor impedance R_{J},
P_{C} = E_{C}² R_{J}/(R_{J}+R_{L})², in the small signal phase, the square of the drain current I_{D} increment is larger than the decrease of the transistor impedance, and the power loss of the transistor increases with the increase of the input signal voltage, when the transistor impedance decreases to equal to the load impedance, at this time, the square of the drain current I_{D} increment is equal to the decrease of the transistor impedance, and the power loss of the transistor is the largest, and the output power is a quarter of the maximum output power, after the maximum power loss is reached, with the increase of the input signal voltage, the square of the drain current I_{D} increment is less than the decrease of the transistor impedance, and the transistor power loss decreases with the increase of the output power and the decrease of the transistor impedance, that is, when the transistor impedance is equal to the load impedance and the output power is a quarter of the maximum output power, the transistor has the largest power loss, due to the transistor impedance R_{J}=L/nAqµn=L/Aqµₙnₙ₀exp[(V_{b}∼+V_{b-}-V_{D})/V_{T}], static resistance: R_{J0}=L/Aqnₙnₙ₀exp (-V_{D}/ V_{T}),and the threshold voltage V_{D} is fixed for each transistor, the load impedance has been determined at the time of the design circuit, therefore, the selection of positive bias voltage V_{b-} with signal voltage V_{b}~ can avoid the maximum power loss point to work, effectively reduce the transistor power loss and reduce the transistor temperature; The above relational quantitative analysis transistor works is used for circuit design and software development; Conductivity of semiconductor electronic components: σ=nqµₙ=qµₙnₙ₀ exp[(V_{b}∼+V_{b-}-V_{D})/V_{T}], and resistivity: ρ=1/nqµₙ=1/qµₙnⁿ⁰exp[(V_{b}∼+V_{b-}-V_{D})/V_{T}], according to new semiconductor electronic principles, static conductivity: determined by intrinsic carrier density nₙ₀ and intrinsic mobility µn, because transistors can be made of a variety of semiconductor materials, the static conductivity and resistivity of different semiconductor materials are different, different semiconductor materials can be used to manufacture transistors with different functions and characteristics; The intrinsic carrier density of silicon is 1.5×10¹⁰, intrinsic mobility: electron 1350/cm², hole 480/cm², the threshold voltage of the silicon transistor is about 0.6 V, and the intrinsic carrier density of germanium is 2.5×10¹³, intrinsic mobility: electron 3900/ cm², hole 1900/ cm² , the threshold voltage of germanium transistor is about 0.25V, the data show that the static conductivity of germanium is three orders of magnitude higher than that of silicon, and the static resistivity of germanium is three orders of magnitude lower than that of silicon, therefore, germanium transistor has high conductivity and threshold voltage is only 1/3 of silicon transistor, for the same working state, the positive bias voltage and switching time of transistor are reduced by 2/3, thus increasing the switching speed of transistor and reducing the power loss of transistor, therefore, semiconductor electronic devices made of germanium, a semiconductor material with high static conductivity and low static resistivity, have better functions and characteristics than semiconductor electronic devices made of silicon materials, it has been proved that according to the principle of new semiconductor electronics, semiconductor electronic devices with higher manufacturing functions and characteristics can be expanded; According to the principle of new semiconductor electronics, the work of semiconductor electronics composed of single or combined junctions is to change the carrier density distribution of the junction, to modulate the conductivity of semiconductor electronic devices, and to complete the conversion and amplification of electrical signals, the work of semiconductor electronic devices is that the change of carrier density distribution changes the conductivity, not emits electrons and does not produce current, so semiconductor electronic devices will not fail and aging, thus, the qualified rate and service life of semiconductor electronic devices and products are improved, and the production cost and usage fee are reduced; Software is developed according to the working principle, structure, characteristics, function, relationship with external stress, relationships, circuit structure, and functions to be completed, for operation and control hardware, new semiconductor electronic principle, technology, passive semiconductor devices, new relationships and circuit structure in all semiconductor electronic technology and equipment, is the fundamental change of hardware, therefore, new semiconductor electronic principle, technology, passive semiconductor devices, new relationships and circuit structure, is the basis for the development of new code, software and operating system.

2. The new semiconductor electronic principle technology and device according to claim 1, **characterized in that**: another method for stabilizing the operating state of the transistor is: in the lower bias circuit of the positive bias voltage circuit of the bipolar junction transistor base and the unipolar field effect (MOS) transistor gate, a thermoelectric element having a negative temperature coefficient is connected in series, the thermoelectric element is in the same temperature as the transistor, and when the voltage of the thermoelectric element is reduced at 20° C. in the class B operating state being approximately equal to the transistor gate valve voltage, in the Class B operating state being slightly lower than the transistor gate valve voltage, in the class B operating state being lower than the transistor gate valve voltage.
